# EUROPÄISCHE PATENTSCHRIFT

(11) **EP 2 453 042 B1**
(45) Veröffentlichungstag und Bekanntmachung des Hinweises auf die Patenterteilung: **13.03.2013**
(21) Anmeldenummer: 11188214.8
(22) Anmeldetag: 08.11.2011
(51) Int. Cl.: C30B 13/04, C30B 29/06, C01B 33/00, G01N 33/20

(54) **Verfahren zur Bestimmung von Verunreinigungen in Silicium**
Method for the determination of impurities in silicon
Procédé de détermination d'impuretés dans du silicium

(30) Priorität: 10.11.2010 DE 102010043702
(43) Veröffentlichungstag der Anmeldung: 16.05.2012
(73) Patentinhaber: Wacker Chemie AG, 81737 München (DE)
(72) Erfinder: Bonauer-Klepp, Kurt, 84489 Burghausen (DE)
(74) Vertreter: Killinger, Andreas

(56) Entgegenhaltungen:
- DE-A1- 4 137 521

## Beschreibung

Gegenstand der Erfindung ist ein Verfahren zur Bestimmung von Verunreinigungen in Silicium.

Im industriellen Maßstab wird Rohsilicium durch die Reduktion von Siliciumdioxid mit Kohlenstoff im Lichtbogenofen bei Temperaturen von etwa 2000 °C gewonnen.

Dabei erhält man sog. metallurgisches Silicium (Si_{mg}, "metallurgical grade") mit einer Reinheit von etwa 98-99 %.

Für Anwendungen in der Photovoltaik und in der Mikroelektronik muss das metallurgische Silicium gereinigt werden. Dazu wird es beispielsweise mit gasförmigem Chlorwasserstoff bei 300-350 °C in einem Wirbelschichtreaktor zu einem Silicium enthaltenden Gas, beispielsweise Trichlorsilan, umgesetzt. Darauf folgen Destillationsschritte, um das Silicium enthaltende Gas zu reinigen.

Dieses hochreine Silicium enthaltende Gas dient dann als Ausgangsstoff für die Herstellung von hochreinem polykristallinem Silicium.

Das polykristalline Silicium, oft auch kurz Polysilicium genannt, wird üblicherweise mittels des Siemens-Prozesses hergestellt. Dabei werden in einem glockenförmigen Reaktor ("Siemens-Reaktor") dünne Filamentstäbe aus Silicium durch direkten Stromdurchgang erhitzt und ein Reaktionsgas enthaltend eine Silicium enthaltende Komponente und Wasserstoff wird eingeleitet.

Beim Siemens-Prozess stecken die Filamentstäbe üblicherweise senkrecht in am Reaktorboden befindlichen Elektroden, über die der Anschluss an die Stromversorgung erfolgt. Je zwei Filamanentstäbe sind über eine waagrechte Brücke (ebenfalls aus Silicium) gekoppelt und bilden einen Trägerkörper für die Siliciumabscheidung. Durch die Brückenkopplung wird die typische U-Form der auch Dünnstäbe genannten Trägerkörper erzeugt.

An den erhitzten Stäben und der Brücke scheidet sich hochreines Polysilicium ab, wodurch der Stabdurchmesser mit der Zeit anwächst (CVD = Chemical Vapour Deposition / Gasphasenabscheidung).

Nach Beendigung der Abscheidung werden diese Polysiliciumstäbe üblicherweise mittels mechanischer Bearbeitung zu Bruchstücken unterschiedlicher Größenklassen weiterverarbeitet, gegebenenfalls einer nasschemischen Reinigung unterzogen und schließlich verpackt.

Das Polysilicium kann aber auch in Form von Stäben oder Stabstücken weiterverarbeitet werden. Dies gilt insbesondere für Verwendung des Polysiliciums in FZ-Verfahren.

Die Silicium enthaltende Komponente des Reaktionsgases ist in der Regel Monosilan oder ein Halogensilan der allgemeinen Zusammensetzung SiHₙX₄₋ₙ (n=0, 1, 2, 3; X = Cl, Br, I). Bevorzugt handelt es sich um ein Chlorsilan, besonders bevorzugt um Trichlorsilan. Überwiegend wird SiH₄ oder SiHCl₃ (Trichlorsilan, TCS) im Gemisch mit Wasserstoff eingesetzt.

Daneben ist es auch bekannt, kleine Siliciumpartikel in einem Wirbelschichtreaktor direkt einem solchen Reaktionsgas auszusetzen. Das dabei erzeugte polykristalline Silicium liegt in Form von Granulaten vor (Granulat-Poly).

Polykristallines Silicium (kurz: Polysilicium) dient als Ausgangsmaterial bei der Herstellung von einkristallinem Silicium mittels Tiegelziehen (Czochralski- oder CZ-Verfahren)- oder mittels Zonenschmelzen (Floatzone oder FZ-Verfahren). Dieses einkristalline Silicium wird in Scheiben (Wafer) zertrennt und nach einer Vielzahl von mechanischen, chemischen und chemo-mechanischen Bearbeitungen in der Halbleiterindustrie zur Fertigung von elektronischen Bauelementen (Chips) verwendet.

Insbesondere wird aber polykristallines Silicium in verstärktem Maße zur Herstellung von ein- oder multikristallinem Silicium mittels Zieh- oder Gieß-Verfahren benötigt, wobei dieses ein- oder multikristalline Silicium zur Fertigung von Solarzellen für die Photovoltaik dient.

Da die Qualitätsanforderungen an Polysilicium immer höher werden, sind Qualitätskontrollen während der gesamten Prozesskette unabdingbar. Untersucht wird das Material beispielsweise hinsichtlich Kontaminationen mit Metallen oder Dotierstoffen. Zu unterscheiden ist die Kontamination im Bulk und die Kontamination an der Oberfläche der Polysiliciumbruchstücke oder -stabstücke.

Es ist auch üblich, das erzeugte Polysilicium zum Zwecke der Qualitätskontrolle in einkristallines Material zu überführen. In diesem Fall wird das einkristalline Material untersucht. Auch hier spielen Metallkontaminationen, die bei den Kundenprozessen in der Halbleiterindustrie besonders kritisch einzuschätzen sind, eine besondere Rolle. Untersucht wird das Silicium aber auch hinsichtlich Kohlenstoff sowie Dotierstoffen wie Aluminium, Bor, Phosphor und Arsen.

Dotierstoffe werden nach SEMI MF 1398 an einem aus dem polykristallinen Material erzeugten FZ-Einkristall (SEMI MF 1723) mittels Photolumineszenz analysiert. Alternativ kommt Niedrigtemeperatur-FTIR (Fourier-Transform IR-Spektroskopie) zum Einsatz (SEMI MF 1630).

FTIR (SEMI MF 1188, SEMI MF 1391) ermöglicht die Bestimmung von Kohlenstoff- und Sauerstoffkonzentrationen.

Grundlagen des FZ-Verfahrens sind beispielsweise in der DE-3007377 A beschrieben.

Beim FZ-Verfahren wird ein polykristalliner Vorratsstab mit Hilfe einer Hochfrequenzspule nach und nach aufgeschmolzen und das schmelzflüssige Material durch Animpfen mit einem einkristallinen Impflingskristall und anschließendem Rekristallisieren in einen Einkristall überführt. Bei der Rekristallisation wird der Durchmesser des entstehenden Einkristalls zunächst kegelförmig vergrößert (Konusbildung) bis ein gewünschter Enddurchmesser erreicht ist (Stabbildung). In der Phase der Konusbildung wird der Einkristall auch mechanisch gestützt, um den dünnen Impflingskristall zu entlasten.

Es hat sich jedoch gezeigt, dass polykristallines Silicium mit hohen Fremdstoffkonzentrationen sowie hochkontaminiertes Material wie z.B. aufbereitetes metallurgisches Silicium ("upgraded metallurgical grade", UMG), das in einen FZ-Einkristall überführt wurde, nicht ohne weiteres mittels Photolumineszenz bzw. FTIR analysisiert werden kann. Die Kontaminationen sind für den mittels Photolumineszenz bzw. FTIR messbaren Bereich zu hoch. Für Dotierstoffe sind Konzentrationen der Größenordnung ppta mit PL (Photolumineszenz), für Kohlenstoff der Größenordnung ppba mit FTIR messbar.

DE 41 37 521 B4 beschreibt ein Verfahren zur Analyse der Konzentration an Verunreinigungen in Siliciumteilchen, dadurch gekennzeichnet, dass teilchenförmiges Silicium in ein Siliciumgefäss gegeben, das teilchenförmige Silicium und das Siliciumgefäss zu monokristallinem Silicium in einer Schwebezone aufarbeitet und die Konzentration an Verunreinigungen, die in dem monokristallinen Silicium vorhanden sind, bestimmt werden.

Als vorteilhaft an diesem Verfahren wird angesehen, dass die Probe durch das Verfahren minimal kontaminiert wird. Das teilchenförmige Silicium soll Elektronikqualität oder eine äquivalente Qualität aufweisen. Bei dem teilchenförmigen Silicium kann es sich um polykristalline oder monokristalline Teilchen oder Fragmente handeln.

Wenn das zu untersuchende Silicium bereits Elektronikqualität aufweist, sind die im Stand der Technik beobachteten Probleme mit den Photolumineszenzmessungen nicht gegeben, da die Kontaminationen auf ausreichend niedrigem Niveau sind. Hier steht also im Vordergrund, dem teilchenförmigen Silicium durch das Schwebezonenverfahren eine andere Form, nämlich eine Stabform zu geben, um solche Messungen vornehmen zu können.

Nachteilig an dem Verfahren ist, dass ein ausreichender Kontakt zwischen den Teilchen und dem Siliciumgefäß bestehen muss, um eine ausreichende Wärmeübertragung sicherzustellen. Dabei besteht die Gefahr, dass das zu analysierende Silicium kontaminiert wird.

Aus der beschriebenen Problematik ergab sich die Aufgabenstellung der Erfindung.

Die Aufgabe wird gelöst durch ein Verfahren zur Bestimmung von Verunreinigungen in Silicium, bei dem aus einem zu untersuchenden Silicium mittels Zonenziehen ein monokristalliner Stab erzeugt wird; dieser monokristalline Stab in wenigstens einem Verdünnungsschritt in eine Hülse aus mono- oder polykristallinem Silicium mit definierter Kohlenstoff- und Dotierstoffkonzentration eingebracht und aus Stab und Hülse mittels Zonenziehen ein verdünnter monokristalliner Stab aus Silicium erzeugt wird; wobei anhand des verdünnten monokristallinen Stabes eine Bestimmung der Verunreinigungen im zu untersuchenden Silicium mittels Photolumineszenz oder FTIR oder beiden vorgenommen wird.

Vorzugsweise weist das zu untersuchende Silicium vor dem wenigstens einen Verdünnungsschritt einen Kohlenstoffgehalt von wenigstens 1 ppma und einen Gehalt an Dotierstoffen von wenigstens 1 ppba auf.

Vorzugsweise erfolgen nach dem wenigstens einen Verdünnungsschritt weitere Verdünnungsschritte mit einer weiteren Hülse aus mono- oder polykristallinem Silicium mit definierter Kohlenstoff- und Dotierstoffkonzentration und dem jeweils nach dem vorangegangen Verdünnungsschritt erhaltenen neuen monokristallinen Stab aus Silicium, um einen verdünnten monokristallinen Siliciumstab zu erzeugen.

Vorzugsweise werden so lange weitere Verdünnungsschritte vorgenommen, bis der verdünnte Siliciumstab einen Kohlenstoffgehalt von weniger als 1 ppma und einen und einen Gehalt an Dotierstoffen von weniger als 1 ppba aufweist.

Ausgangspunkt des Verfahrens ist aufbereitetes metallurgisches Silicium oder polykristallines Silicium, das mit Kohlenstoff und mit Dotierstoffen verunreinigt ist. Das Material ist derart mit Kohlenstoff und/oder Dotierstoffen kontaminiert, dass eine Messung der Verunreinigungen mittels Photolumineszenz zunächst nicht möglich ist.

Das Ausgangsmaterial liegt vorzugweise in Form eines Dünnstabes vor, wie er sich nach Abscheidung an einem Filamentstab in einem Siemensreaktor ergibt.

Aus diesem Dünnstab wird mittels FZ (Floatzone)-Zonenziehen ein Einkristallstab gewachsen.

Dieser Einkristallstab hat einen kreisförmigen Querschnitt und vorzugsweise einen Durchmesser von 2 bis 35 mm.

Bevor beim FZ-Wachstum der Enddurchmesser von 2 bis 35 mm erreicht wird, wird vorzugsweise ein sog. Dünnhals gezogen, um versetzungsfreies Wachstum zu erreichen und einen geeigneten Stab als Füllung der Hülse für den Verdünnungsschritt zu schaffen.

Der aus dem Ausgangsmaterial gewachsene einkristalline Stab wird anschließend in eine Hülse aus einkristallinem oder polykristallinem Silicium eingebracht.

Der einkristalline (oder polykristalline) Stab, der sich in der Siliciumhülse befindet, wird dann mittels FZ in einen einkristallinen Stab überführt. Auch hier wird vorzugsweise ein sog. Dünnhals gezogen, um versetzungsfreies Wachstum zu erreichen und einen geeigneten Stab als Füllung der Hülse für den nächsten Verdünnungsschritt zu schaffen.

Vorzugsweise entspricht der Innendurchmesser der Hülse in etwa dem Durchmesser des zuvor erzeugten monokristallinen Stabs.

Es ist jedoch auch möglich und besonders bevorzugt, dass der Stabdurchmesser kleiner ist als der Innendurchmesser der Hülse.

Es hat sich nämlich gezeigt, dass versetzungsfreies Wachstum auch dann möglich ist, wenn sich zwischen Innenwand der Hülse und der Mantelfläche des einkristallinen Stabs ein Hohlraum befindet.

Vorzugsweise besteht zwischen Hülse und zylindrischem Kristall kein Kontakt. Dass eine solche Anordnung einen defektfreien Einkristall liefert, der gleichzeitig als Ausgangsmaterial für weitere Verdünnungsschritte dienen kann, ist überraschend.

Falls zwischen Hülse und dem zylindrischen Kristall kein Kontakt besteht, kann zudem auf jegliche mechanische Bearbeitungen des zylindrischen Kristalls verzichtet werden. Dies ist von Vorteile, zumal solche mechanischen Bearbeitungen stets eine Ursache für zusätzliche Kontamination bedeuten könnten.

Die Siliciumhülse lässt sich durch Ausbohren aus einem ein- oder polykristallinen Stabs erzeugen.

Durch die Erzeugung eines neuen einkristallinen Stabs aus dem ursprünglichen einkristallinen (oder polykristallinen)Stab und der Siliciumhülse ist es möglich, die Konzentration an Fremdstoffen im Silicium zu verdünnen.

Das ein- oder polykristalline Material der Hülse weist ein definiertes Niveau an Verunreinigungen mit Kohlenstoff und Dotierstoffen auf. Die Konzentration an Verunreinigungen in der Siliciumhülse ist idealerweise auf deutlich niedrigerem Niveau als die Konzentration im zu untersuchenden Silicium.

So wird durch das Wachstum eines neuen Stabs aus Hülse und ursprünglichem Stab eine Verdünnung der Verunreinigungen erreicht.

Es ist auch bevorzugt, einen solchen Verdünnungsschritt mehrfach auszuführen.

Bei stark kontaminiertem Ausgangsmaterial sind solche merhfache Verdünnungen zwingen erforderlich, um in für die Photolumineszenz messbare Bereiche vorzudringen.

Dies lässt sich dadurch bewerkstelligen, dass der nach dem ersten Verdünnungsschritt erhaltene einkristalline Stab wiederum in eine Hülse aus Silicium eingebracht wird und Stab/Hülse erneut einem FZ-Prozess unterzogen werden.

Durch jeden zusätzlichen Verdünnungsschritt wird eine weitere Verdünnung der Konzentration mit Verunreinigungen erreicht.

Falls nach dem ersten Verdünnungsschritt die Konzentration an Verunreinigungen bereits auf einem Niveau ist, das eine Bestimmung der Konzentration mittels Photolumineszenz ermöglicht, wird vorzugsweise kein weiterer Verdünnungsschritt durchgeführt.

Die Konzentration an Verunreinigungen ist dann auf einem Niveau, das eine Bestimmung der Konzentration mittels Photolumineszenz ermöglicht, wenn der Kohlenstoffgehalt weniger als 1 ppma und der Gehalt an Dotierstoffen weniger als 1 ppba beträgt.

Bei der Bestimmung der Konzentrationen mittels Photolumineszenz ist die Verdünnung selbstverständlich zu berücksichtigen. Da der Grad der Verunreinigung des Materials der Siliciumhülse jedoch bekannt ist, sich also im mittels Photolumineszenz messbaren Bereich befindet, macht es dem Fachmann keine Probleme, mittels der Konzentration der Verunreinigungen im aus (Stab/Hülse) erzeugten Einkristall bzw. nach n Verdünnungsschritten im aus (Stab/n * Hülse) erzeugten Einkristall die exakte Konzentration der Verunreinigung im zu untersuchenden Silicium zu ermitteln.

Bei hohen Kristallwachstumsgeschwindigkeiten von mehr als 10 mm/min, was bevorzugt ist, kann dabei Segregation in erster Näherung vernachlässigt werden, da hohe Segregationskoeffizienten resultieren. Der eingesetzte zylindrische Einkristall, der vorzugsweise einen Kristalldurchmesser von 2-35 mm aufweist, wird vorzugsweise mit einer derart hohen Ziehgeschwindigkeit und niedrigen effektiven Schmelzenhöhe hergestellt. Bei Bor und Phosphor treten dann praktisch keinerlei Segregationseffekte auf, was das Verfahren weniger aufwändig macht, zumal im Stand der Technik Segregationseffekte stets zu berücksichtigen waren (SEMI MF 1723-1104).

Es hat sich gezeigt, dass das Verfahren auch bei unbegrenzt hohen Dotierstoffkonzentrationen eine Quantifizierung der Dotierelemente mit der Methode der Photolumineszenz ermöglicht.

### Beispiele

Untersucht wurden stabförmige Proben aus polykristallinem Silicium und metallurgischem Silicium.

Die Proben wiesen einen Durchmesser von ca. 5 mm auf.

Aus diesem Proben wurden mittels FZ einkristalline Stäbe mit einem Durchmesser von etwa 12 mm gewachsen.

Als Hülsen wurden undotierte polykristalline Siliciumhülsen (Durchmesser ca. 19 mm) verwendet.

Es wurden 4 Verdünnungsschritte durchgeführt.

Nach den ersten drei Verdünnungsschritten befanden sich die Konzentrationen von Bor und Phosphor nicht im messbaren Bereich.

Nach dem vierten Verdünnungsschritt befanden sich die Konzentrationen der Dotierstoffe im messbaren Bereich.

Dazu wurde an einer definierten Stelle des Einkristalls eine Messscheibe entnommen und diese Photolumineszenz-Messungen unterzogen.

Es ergaben sich 79 ppta Phosphor und 479 ppta Bor.

Daraus ließen sich die Konzentrationen der ursprünglichen Proben bestimmen. Es ergaben sich 1,0 ppma Phosphor und 6,3 ppma Bor.

Bezüglich des Kohlenstoffes befand sich dessen Konzentration bereits nach der dritten Verdünnung im messbaren Bereich. Es ergab sich 87 ppba.

Für die ursprüngliche Probe errechneten sich 833 ppma an Kohlenstoff.

## Patentansprüche

1. Verfahren zur Bestimmung von Verunreinigungen in Silicium, bei dem aus einem zu untersuchenden Silicium mittels Zonenziehen ein monokristalliner Stab erzeugt wird; dieser monokristalline Stab in wenigstens einem Verdünnungsschritt in eine Hülse aus mono- oder polykristallinem Silicium mit definierter Kohlenstoff- und Dotierstoffkonzentration eingebracht und aus Stab und Hülse mittels Zonenziehen ein verdünnter monokristalliner Stab aus Silicium erzeugt wird; wobei anhand das verdünnten monokristallinen Stabes eine Bestimmung der Verunreinigungen im zu untersuchenden Silicium mittels Photolumineszenz oder FTIR oder beiden vorgenommen wird.

2. Verfahren nach Anspruch 1, wobei das zu untersuchende Silicium vor dem wenigstens einen Verdünnungsschritt einen Kohlenstoffgehalt von wenigstens 1 ppma und einen Gehalt an Dotierstoffen von wenigstens 1 ppba aufweist.

3. Verfahren nach Anspruch 1 oder 2, wobei nach dem wenigstens einen Verdünnungsschritt weitere Verdünnungsschritte mit einer weiteren Hülse aus mono- oder polykristallinem Silicium mit definierter Kohlenstoff- und Dotierstoffkonzentration und dem jeweils nach dem vorangegangen Verdünnungsschritt erhaltenen neuen monokristallinen Stab aus Silicium vorgenommen werden, um einen verdünnten monokristallinen Siliciumstab zu erzeugen.

4. Verfahren nach Anspruch 3, wobei Verdünnungsschritte vorgenommen werden, bis der verdünnte Siliciumstab einen Kohlenstoffgehalt von weniger als 1 ppma und einen Gehalt an Dotierstoffen von weniger als 1 ppba aufweist.

## Claims

1. Method for the determination of impurities in silicon, in which a monocrystalline rod is produced by means of zone refining from silicon to be tested; this monocrystalline rod is introduced, in at least one dilution step, into a casing made of mono- or polycrystalline silicon having defined carbon and dopant concentrations and a diluted monocrystalline rod of silicon is produced from the rod and casing by means of zone refining; wherein the determination of impurities in the silicon to be tested is carried out with the aid of the diluted monocrystalline rod by means of photoluminescence or FTIR or both.

2. Method according to Claim 1, wherein the silicon to be tested has a carbon content of at least 1 ppma and a dopant content of at least 1 ppba before the at least one dilution step.

3. Method according to Claim 1 or 2, wherein after the at least one dilution step, further dilution steps are carried out with a further casing made of mono- or polycrystalline silicon having defined carbon and dopant concentrations and the new monocrystalline rod of silicon respectively obtained after the preceding dilution step, in order to produce a diluted monocrystalline silicon rod.

4. Method according to Claim 3, wherein dilution steps are carried out until the diluted silicon rod has a carbon content of less than 1 ppma and a dopant content of less than 1 ppba.

## Revendications

1. Procédé pour la détermination d'impuretés dans du silicium, dans lequel à partir d'un silicium à examiner on produit par tirage de zone une barre monocristalline ; dans au moins une étape de dilution on introduit cette barre monocristalline dans un manchon à base de silicium mono- ou polycristallin à teneur définie en carbone et substances de dopage et à partir de la barre et du manchon on produit par tirage de zone une barre monocristalline à base de silicium, diluée ; dans lequel à l'aide de la barre monocristalline diluée on effectue par photoluminescence ou FTIR ou les deux une détermination des impuretés présentes dans le silicium à examiner.

2. Procédé selon la revendication 1, dans lequel le silicium à examiner présente avant ladite au moins une étape de dilution une teneur en carbone d'au moins 1 ppma et une teneur en substances de dopage d'au moins 1 ppba.

3. Procédé selon la revendication 1 ou 2, dans lequel après ladite au moins une étape de dilution on effectue d'autres étapes de dilution avec un autre manchon à base de silicium mono- ou polycristallin à teneur définie en carbone et substances de dopage et la nouvelle barre monocristalline à base de silicium obtenue chaque fois après l'étape de dilution précédente, afin de produire une barre de silicium monocristalline diluée.

4. Procédé selon la revendication 3, dans lequel on effectue des étapes de dilution jusqu'à ce que la barre de silicium diluée présente une teneur en carbone de moins de 1 ppma et une teneur en substances de dopage de moins de 1 ppba.
